(19) Europäisches Patentamt
European Patent Office
Office européen des brevets

(11) Publication number: **0 125 086**
**A2**

(12) # EUROPEAN PATENT APPLICATION

(21) Application number: **84302899.4**

(51) Int. Cl.³: **G 03 F 1/00**

(22) Date of filing: **30.04.84**

(30) Priority: **02.05.83 US 490479**

(43) Date of publication of application: **14.11.84 Bulletin 84/46**

(84) Designated Contracting States: **AT CH DE FR GB IT LI**

(71) Applicant: **MINNESOTA MINING AND MANUFACTURING COMPANY**
**3M Center, P.O. Box 33427**
**St. Paul, MN 55133(US)**

(72) Inventor: **Fisch, Richard S. Minnesota Mining and Man. Co.**
**2501 Hudson Road P.O. Box 33427**
**St, Paul Minnesota 55133(US)**

(72) Inventor: **Barjesteh, Hamid Minnesota Mining and Man. Co.**
**2501 Hudson Road P.O. Box 33427**
**St, Paul Minnesota 55133(US)**

(74) Representative: **Baillie, Iain Cameron et al,**
**c/o Ladas & Parry Isartorplatz 5**
**D-8000 München 2(DE)**

(54) **Imageable vapor-deposited colorant layers.**

(57) Vapor deposited colorant layers can be used to provide optical density in photoresist imaging articles.

The use of organic materials containing carbonyl groups (which are not part of carboxyl groups), phenoxy groups, ester groups, or alcohol groups over vapor deposited metal layers improves their mar resistance. These organic materials can improve the properties of the metal layer when used in photoresist imaging films.

EP 0 125 086 A2

0125086

DESCRIPTION

# IMAGEABLE VAPOR-DEPOSITED COLORANT LAYERS

## BACKGROUND OF THE INVENTION

### Field of the Invention

This invention relates to photosensitive articles comprising vapor-deposited colorant layers on a substrate and a photosensitive resist layer over the colorant layer. The invention further relates to such photosensitive articles having protective organic layers on the surface of the vapor-deposited colorant and/or a vapor deposited metal layer which is preferably included in the photosensitive articles.

In particular, the present invention relates to an imageable article having at least one vapor-deposited colorant layer on the surface of a substrate. The substrate may or may not already have a vapor-deposited metal layer and/or other layers present on the surface where the colorant is vapor-deposited. The preferred metal layer is generally formed on a supporting base by any of the various vapor-depositing techniques prior to application of the colorant. Prior to subjecting the vapor-deposited colorant and/or metal layer to any physical treatments or stress likely to damage the continuity of the coating (e.g., rolling, folding, bending, and the like), an organic protective layer is desirably vapor-deposited onto the surface of the colorant and/or metal.

### Description of the Prior Art

Colorants, such as dyes and pigments, are used in a wide variety of imaging procedures to provide optical density for viewable images. Such widely diverse technologies as color photography, diazonium salt coupling, lithographic and relief printing, dye-bleach imaging, leuco-dye oxidation, sublimation transfer of dyes and photoresistive imaging systems all may use dyes and

pigments to form the viewable optical densities. Examples of some of these types of technologies may be found, for example, in U.S. Patent Nos. 3,136,637, 3,671,236, 4,307,182, 4,262,087, 4,230,789, 4,212,936, 4,336,323 and the like. In all of these systems, the colorant is present in the imageable article within a carrier medium such as a solvent or polymeric binder. In the transfer of dyes by sublimation, it is only the image that consists of essentially pure dye on a receptor sheet. Each of these various imaging technologies has its various benefits and handicaps as measured by their respective complexity, consistency, image quality, speed, stability and expense.

Vapor-deposited layers of metals on substrates suffer from a number of serious limitations in their use as imaging materials, as in photoresist imaging articles. The metal layers tend to be difficult to vapor-deposit without defects (which reduces their ability to faithfully record images) and they are readily subject to the generation of additional defects during handling, transportation and use.

Vapor-deposited layers of metals, particularly those on flexible webs, tend to be soft and easily rubbed off. These defects are particularly unacceptable where such layers are to be used as part of an imaging system consisting of a vapor-deposited metal layer and an overcoated photoresist or photopolymer layer. Marks, scuffs, kinks, or abrasions in the metal layer produce voids or areas in the film which contain no useful image, thus interrupting the faithfulness of the image. These photographic defective areas have been called by various names such as pinholes, cinch marks, scuffs, etc., depending on where and how the abrasion was produced. In order to avoid such defects, a protective resin layer is generally coated on the metal layer. This is often done in a separate coating operation on a different coating machine. The difficulty with this practice, however, is that the unprotected vapor-coated metal film must be wound after the vapor-coating operation to transport the material

to the more conventional resin coater. Defects such as cinch marks, abrasions, and kinks are often produced during this winding operation.

In order to avoid the problems described above, several attempts have been made to vapor-deposit the metallic and organic layers in the same vacuum chamber, thus eliminating the need to wind the film in a roll between coating operations. One such process is described in U.S. 4,268,541. Here the vapor-deposition chamber is divided into 2 sections, by means of a partition, thereby separating the metal deposition area from the organic deposition section. Thus the organic protective layer is deposited over the metal layer without the need to rewind the roll in between the two coating operations.

The organic compounds used in U.S. Pat. 4,268,541 include polymers (for example, those derived from methacrylic acid and acrylic acid), low molecular weight organic compounds containing a carboxyl group (e.g., compounds such as abietic acid, isophthalic acid, behenic acid, terephthalic acid, phthalic acid, etc., and a few random compounds (e.g., Rhodamine B, rosin, a phthalocyanine, a monosaccharide, and an oligosaccharide).

The technique and materials described in U.S. 4,268,541 have been found to be suitable for only limited uses. The layer thickness of 30-600 nm specified is not suitable for many imaging film constructions, and for many processing techniques. In particular, the friction properties of the coating cause layers of the coated material which are stacked or rolled to slide and move out of register. In rolled form, telescoping of the roll is quite serious. This can cause serious delays and expense in further use of the film even though the metal layer is protected by the coating.

Organic protection layers located between the metal layer and a photoresist layer can drastically affect the oxidizing or etching step and the quality of the resulting image. For, example, excessive thickness of such

layers may provide a preferential pathway for the developer or etch solution thereby resulting in image degradation or fine detail loss. This is especially true of material whose final designation is copy or contact reprographic work. Films such as these, called lith or contact films, depend on fine dot arrays to reproduce image tone. Fine dots (3-5%) may be undercut and etched away thereby degrading the quality of the reproduction.

The relatively thick layer of some acid-containing protective materials such as disclosed in U.S. Pat. No. 4,268,541 can also interfere with the etching of the metal by neutralizing the alkaline metal etching solution. Such neutralization inhibits the formation of an etched metal image and thus interferes with the formation of an image of acceptable quality.

Another attempt at overcoming the abrasion problems is described in Japanese patent publication number 56/9736. In this case, the metal and the organic compound are deliberately coated as a single layer; i.e., the metal and organic vapors are substantially mixed in the vapor stream before they are deposited on the support. This is not completely satisfactory because the heated metal vapor can carbonize or decompose the organic material resulting in an unacceptable product. Also, the thickness of the layer is required to be at least 20 to 1000 nm. The scope of organic materials is also quite specific and generally emphasizes organic acid materials.

U.S. Patent No. 4,271,256 discloses the use of dyes under a vapor-coated metal layer to enhance radiation absorption, but does not use a photoresist layer with the article.

## SUMMARY OF THE INVENTION

The application of a vapor-deposited colorant (dye or pigment) layer to the surface of a substrate provides useful optical density for photoresistive imaging articles. The provision of a photoresist layer over the

vapor-deposited colorant layer provides a photoresist imaging article. The colorant forms an easily controlled, uniform, continuous layer of optical density that can be easily removed by mechanical (e.g., buffing) or dissolving means. All radiation absorbing dyes and pigments are useful in this type of article.

The combination of the vapor-deposited colorant layer with a substrate having a vapor-deposited metal layer (including layers comprising metal and metal compounds or metal and metal oxides in a dispersion) thereon provides uniquely desirable results. The metal provides high optical densities and the colorant layer masks existing and later formed defects without any adverse effect on image quality. The vapor-deposited colorant layer may be applied directly onto the surface of the vapor-deposited metal layer (including metal/metal oxide or metal/metal sulfide dispersions as disclosed in U.S. Patent No. 4,364,995) or onto other non-resistive, developer-soluble layers already on the vapor-deposited metal layer (such as an abrasion-protective layer, as in U.S. Patent No. 4,268,541).

The use of abrasion-protective layers on the vapor-deposited metal layer and/or the vapor-deposited color layer is a preferred construction of the present invention.

Of critical importance in the use of dyes and pigments is the prevention of penetration of the vapor-deposited dye or pigment layer into the photosensitive layer. The use of pigments or dyes insoluble and/or incompatible with the adjacent photosensitive layer or the use of a thin, vapor-deposited organic barrier layer between the dye/pigment and the photosensitive layer is essential. The penetration of dyes and pigments into the photosensitive layer generates a disuniformity of speed in the vertical dimension of the photographic film which adversely affects the photoinitiated change in solubility essential to imaging. Such variations allow for undercutting or incomplete image cleanout in negative and

positive modes, respectively. Although two materials disclosed but not exemplified in U.S. Patent No. 4,268,541 qualify as a dye (Rhodamine B) or pigment (phthalocyanine), they are required to be integral (e.g., soluble or compatible) with the photosensitive resist layer.

The application of layers of organic material with a vapor pressure at 20°C no greater than 1-n-octanol said material having 1) carbonyl groups (including those which are part of carboxyl groups), 2) phenoxy groups, 3) ester groups, 4) urea groups, 5) alcohol groups, 6) phthalocyanine or 7) saccharides onto vapor-deposited colorant or metal surfaces has been found to provide excellent damage resistance to the metal layer. The presence of these organic materials on the vapor-deposited metal layer in photoresist imaging constructions provides for uniform development characteristics in the image. These first five materials (excluding the carboxyl compounds) reduce or eliminate the low friction properties attendant with the use of acids as protective layers, and because of reduced acidity these materials do not neutralize alkaline developing solutions as much as acid protective layers.

## DETAILED DESCRIPTION OF THE INVENTION

The photosensitive article of the present invention comprises a substrate, an optical density providing, vapor-deposited colorant layer and a photosensitive resist layer which is non-integral with the vapor-deposited colorant layer. The substrate may comprise a unitary layer or may comprise a carrier layer having a vapor-deposited metal layer thereon or both a vapor-deposited metal layer and an abrasion-protective, vapor-deposited organic layer.

The term "non-integral" according to the practice of the present invention means that the photosensitive resist layer (as actually constituted) when deposited over the colorant layer (or over the colorant layer further coated by a vapor-deposited barrier layer of an organic material soluble in photoresist developer [i.e., aqueous alkaline solution at pH 13+, preferably as disclosed in

U.S. Patent No. 4,314,022]) does not pick up or absorb more than ten percent by weight of the colorant. Preferably less than five percent and more preferably less than two percent by weight of colorant would be picked up or absorbed by the coated photoresist layer.

The dye or pigment must be coated in sufficient thickness as to provide an optical density of at least 0.3 to a 10 nm band of the electromagnetic spectrum between 280 and 900 nm (preferably between 400 and 700 nm), preferably an optical density of at least 0.6, more preferably at least 0.8 and most preferably at least 1.0 is provided by the dye. Any dye or pigment from any chemical class which can be vapor-deposited can be used in the practice of the present invention. This includes, but is not limited to, methines, anthraquinones, oxazines, azines, thiazines, cyanines, merocyanines, phthalocyanines, indamines, triarylmethanes, benzylidenes, azos, monoazones, xanthenes, indigoids, oxonols, phenols, naphthols, pyrazolones, etc. Dyes or pigments other than Rhodamine B and phthalocyanines are particularly desired. The thickness of the layer depends upon the ability of the colorant to provide at least the minimum optical density. The vapor-deposited layer may be as thin as a few nanometers (e.g., three or ten nanometers) and may be as thick as a thousand nanometers. A general range would be three (3) to one thousand (1000) nanometers and a preferred range would be ten (10) to seven hundred (700) nanometers or ten (10) to two hundred (200) nanometers. A more preferred range would be ten (10) to one hundred (100) nanometers thickness for the dye or pigment. A plurality of dye layers or a mixture of dyes may be used in a single layer. More importantly, the dye should provide a transmission optical density of at least 0.3. Ranges of density from 0.3 to 7.0 and higher are obtainable. Preferably optical densities of at least 0.5 or at least 1.0 should be provided. A range of 1.0 to 5.0 for the maximum optical density at the wavelength of maximum absorbance of the dye is a useful goal, obtainable in the practice of the present invention.

The article of the present invention further comprises a substrate, a vapor-deposited metal layer on at least one surface of said substrate, a vapor-deposited colorant layer on the metal layer, and optionally a protective organic layer on either or both of said metal layer and colorant layer comprising a material having phenoxy groups, alcohol groups, urea groups, ester groups, saccharide, or carbonyl groups (which may be part of carboxyl groups). A photoresist layer non-integral with the colorant layer is coated over said protective layer. It is preferred that there be no substantial amount of radiation absorbing material between the photoresist layer and the vapor-deposited colorant layer. The structure with the dye or pigment layer on a substrate, with a vapor deposited metal layer between the vapor-deposited colorant layer and a photoresist layer is a useful structure which is not in that preferred construction class. In such a structure, the dye would have to be bleached or dissolved to remove it after etching of the metal layer.

The substrate may be any surface or material onto which metal may be vapor-deposited. The substrate may be rough or smooth, transparent or opaque, and continuous or porous. It may be of natural or synthetic polymeric resin (thermoplastic or thermoset), ceramic, glass, metal, paper, fabric, and the like. For most commercial purposes the substrate is preferably a polymeric resin such as polyester (e.g., polyethyleneterephthalate), cellulose ester, polycarbonate, polyvinyl resin (e.g., polyvinylchloride, polyvinylidene chloride, polyvinylbutyral, polyvinylformal), polyamide, polyimide, polyacrylate (e.g., copolymers and homopolymers of acrylic acid, methacrylic acid, n-butyl acrylate, acrylic anhydride and the like), polyolefin, and the like. The polymer may be transparent, translucent or opaque. It may contain fillers such as carbon black, titania, zinc oxide, dyes, pigments, and of course, those materials generally used in the formation of films such as coating aids, lubricants, antioxidants, ultraviolet radiation absorbers, surfactants, catalysts and the like.

The vapor-deposited metal layer may be any vapor-deposited metal or metalloid layer. According to the practice of the present invention, the term metal layer is defined as a layer comprising metal, metal alloys, metal salts, and metal compounds. The corresponding meaning applies to the term metalloid layer. The term metal in metal layer is defined in the present invention to include semi-metals (i.e., metalloids) and semiconductor materials. Metals include materials such as aluminum, antimony, beryllium, bismuth, cadmium, chromium, cobalt, copper, gallium, germanium, gold, indium, iron, lead, magnesium, manganese, molybdenum, nickel, palladium, rhodium, selenium, silicon, silver, strontium, tellurium, tin, titanium, tungsten, vanadium, and zinc. Preferably the metal is selected from aluminum, chromium, nickel, tin, titanium and zinc. More preferably the metal is aluminum. Metal alloys such as aluminum-iron, aluminum-silver, bismuth-tin, and iron-cobalt alloys are included in the term metal layer and are particularly useful. Metal salts such as metal halides, metal carbonates, metal nitrates and the like are useful. Metal compounds such as metal oxides and metal sulfides are of particular utility in imaging systems. Metal layers comprising mixtures of these materials such as mixtures of metal-metal oxides, metal-metal salts, and metal salts-metal oxides are also of particular interest. U.S. Patent No. 4,364,995 teaches a method by which such coatings could be provided.

The thickness of the vapor-deposited metal layer depends upon the particular needs of the final product. In imaging constructions, for example, the thickness should be at least about 3 nm. Generally, the layer would be no thicker than 750 nm which would require a long etching period. A more practical commercial range would be between 10 and 500 nm. A preferred range would be between 20 and 400 nm and a more preferred range would be between 25 and 300 nm or 30 and 200 nm.

It is preferred that the majority of the cross-section of the metal layer consist essentially of metal,

metal alloys, metal salts and metal compounds. Traces of up to 10% or more of other materials may be tolerated generally in the layer, and in fact in certain processes of manufacture the boundary region of the metal layer and the protective layer may have a graded or gradual change from 100% metal to 100% organic material. But metal layers with the majority (at least 50%) of its cross-section consisting essentially of metals, metal alloys, metal salts, metal compounds and combinations thereof are preferred. The metal layer should have fewer than 100, preferably fewer than 50, and more preferably fewer than 30 defects per 177 $mm^2$.

Vapor-deposition of the colorant or metal layers may be accomplished by any means. Thermal evaporation of the metal or colorant, ion plating, radio frequency sputtering, A.C. sputtering, D.C. sputtering and other known processes for deposition may be used in the practice of the present invention. The pressure may vary greatly during coating, but is usually in the range of $10^{-6}$ to $10^{-4}$ torr.

The organic protective layer may comprise a material with a vapor pressure at 20°C no greater than that of 1-n-octanol selected from the group consisting of 1) organic materials having carbonyl groups (which may be but are not required to be part of carboxyl groups), 2) phenoxy groups, 3) alcohols or 4) saccharides. The term "organic material" is used because the protective coating does not have to be a single compound or a monomeric compound. In addition to those types of materials, dimers, trimers, oligomers, polymers, copolymers, terpolymers and the like may be used.

The organic materials containing carbonyl groups which are not part of a carboxyl group, for example, include 1) amides, such as phthalamide, salicylamide, urea formaldehyde resins, and methylene-bis-acrylamide, and 2) anilides, such as phthalanilide and salicylanilide. It has been found that these organic materials may be used in layers as thin as 1 nm and provide good abrasion or mar

protection. They may be used in thicknesses of up to 600 nm, but without dramatic improvement of results, and in fact often with some diminution of properties. A preferred range would be between 3 and 200 nm, more preferably between 5 and 100 nm, and most preferably at least 5 and lower than 30 or 20 nm.

The organic material containing ester groups includes such materials as polyester oligomers, low molecular weight polyester polymers (e.g., polyethyleneterephthalate, polyethyleneisophthalate, etc. having molecular weights between 5,000 and 50,000), diallyl phthalate (and its polymers), diallyl isophthalate (and its polymers), monomethyl phthalate, carboxylic acid alkyl esters, and the like.

The organic material containing phenoxy groups include such materials as Bisphenol A, and low molecular weight phenol formaldehyde resins (e.g., Resinox®). The alcohol containing materials would include 1-n-octanol, dodecanol, benzyl alcohol and the like.

The organic material should be vapor-depositable as this is the general method preferred for application of the protective layer. The organic material may, for example, be deposited in the apparatus and procedures disclosed in U.S. Patent No. 4,268,541. The partition or baffle described in that apparatus (e.g., Example 1) has not been found to be essential. The two vapor streams (i.e., metal and organic material streams) may be physically spaced apart or directed so that the coating zones for the two materials do not completely overlap. No serious problem has been found even when 50% of each of the coating zones overlap (so that at least 50% of the thickness of the metal layer consists essentially of metal, metal salts, metal compounds, and combinations thereof), although this is not a preferred construction. It is preferred that less than 25% of the total weight of the metal component be in such an overlapping or mixing zone and more preferably less than 10% or even 0% be in such

zones. The recitation of a metal layer in the practice of the present invention requires, however, that at least a region of the coating, usually adjacent to the substrate, consists essentially of a metal layer without a dispersed phase of organic material therein. According to the present invention, the dye or colorant coating is preferably between the metal or metalloid layer and the resist layer (if a metal layer is present). A protective layer may be present over the metal (or metalloid) layer and/or over the dye layer, but beneath the resist layer.

The photoresist layer may be either a negative-acting or positive acting photoresist as known in the art. Positive-acting photoresist systems ordinarily comprise polymeric binders containing positive-acting diazonium salts or resins such as those disclosed, for example, in U.S. Patents Nos. 3,046,120, 3,469,902 and 3,210,239. The positive-acting photosensitizers are commercially available and are well reported in the literature. Negative-acting photosensitive resist systems ordinarily comprise a polymerizable composition which polymerizes in an imagewise fashion when irradiated, such as by exposure to light. These compositions are well reported in the literature and are widely commercially available. These compositions ordinarily comprise ethylenically or polyethylenically unsaturated photopolymerizable materials, although photosensitive epoxy systems are also known in the art. Preferably ethylenically unsaturated photopolymerizable systems are used, such as acrylate, methacrylate, acrylamide and allyl systems. Acrylic and methacrylic polymerizable systems are most preferred according to the practice of the present invention. U. S. Patents Nos. 3,639,185, 4,247,616, 4,008,084, 4,138,262, 4,139,391, 4,158,079, 3,469,982, U.K. Patent No. 1,468,746, disclose photosensitive compositions generally useful in the practice of the present invention. U. S. Patent No. 4,314,022 discloses etchant solutions particularly useful in the practice of the present invention.

Acutance dyes may be included within the photoresist layer without rendering that layer "integral" with the colorant layer. The acutance dye, even if it were selected to be the same or different from the colorant, would be homogeneously dispersed in the photoresist layer. The acutance dye would not have been picked up or absorbed from the colorant layer, and to be "non-integral", less than ten percent by weight of the colorant must be picked up by the photosensitive layer as constituted, which includes the acutance dye already present. Where the colorant would, in fact, ordinarily be absorbable, soluble, or picked up by direct contact with the applied photosensitive resist layer, the use of a barrier layer of the same types of materials used to protect the metal layer (exclusive of any soluble dyes) would be used as a barrier layer for the colorant layer, between it and the photosensitive layer, rendering the colorant layer non-integral with the resist layer.

The following examples further illustrate practice of the present invention.

Example 1

Examples 1-5 show substrates which are usefully combined with vapor-deposited colorant layers of the present invention.

Using the apparatus described in U.S. Patent No. 4,268,541 without a baffle, a $10^{-4}$m polyester web was coated by vacuum deposition with 70nm of aluminum. During the same operation in the same vacuum chamber a layer of a commercially available terpolymeric acrylate material (derived from 62% methylmethacrylate, 36% n-butylacrylate and 2% acrylic acid by weight) was applied. This sample represents an article made according to the teachings of U.S. Patent 4,268,541. A control length of non-organic-coated aluminum film was also produced. Ellipsometric measurements of the resultant organic/metal package

indicated that the thickness of the acrylate layer was 30.5nm.

The resultant aluminum plus organic coated material was examined by way of transmitted light and exhibited very few pinholes or defects. The otherwise soft aluminum layer of this package could not be rubbed off using thumb pressure. The non organic coated aluminum film could be rubbed off using thumb pressure.

Both the organic vapor coated sample and the unprotected sample were immersed in a bath of 1.2% sodium hydroxide and 3% of the tetra sodium salt of nitrilotriacetic acid at 32°C. The unprotected Al layer was uniformly, cleanily oxidized away in 15 seconds. The organic-protected layer was not cleanly removed. In fact, the aluminum lifted off in sections during the immersion time and then the aluminum generally oxidized in solution.

Example 2

Using the apparatus described in the Example 1, a 2000 meter continuous web was vapor coated with a 70nm layer of aluminum and immediately thereafter in the same chamber, a 10 nm layer of terephthalic acid was applied. At the 1400 meter level, the terephthalic coated roll telescoped on itself and telescoped further when removed from the chamber. After removal from the chamber, the vapor-coated aluminum/terephthalic acid roll was judged to be unacceptable for production purposes.

Example 3

Using the technique described in Example 1, three more rolls of 2000 meters were coated and a different organic material applied to the aluminum of each of these rolls. Roll A contained an organic layer on top of the aluminum layer) consisting of Resinox, a phenol formaldehyde condensate resin made by the Monsanto Corp.

Roll B was identical to Roll A except than an organic layer of Vitel 200, a low molecular weight polyester resin (approximately 10,000 molecular weight) made by and commercially available from Goodyear was applied to the aluminum layer. Roll C consisted of a control roll of vapor-coated aluminum film identical to rolls A and B with no organic protective coating.

None of these three rolls telescoped.

Example 4

Using the apparatus of Example 1, the following materials were applied to vapor-coated aluminum webs in various thicknesses from 15 to 250 nm.

1) Dimethyl terephthalate
2) Phthalic anhydride
3) Mono methyl phthalate
4) Dapon 35 - a diallyl phthalate prepolymer made by FMC Corp.
5) Bisphenol A
6) Epon 828 - an epoxy resin made by the Shell Corp.
7) Michlers Ketone
8) Benzophenone
9) Benzyl alcohol
10) Salacylamide

These materials were unrolled after coating and inspected with a 10X hand lens by transmitted light. The defects in an area of $177mm^2$ were counted and compared to those of a non organic coated aluminum film prepared as a control. The control film exhibited defect levels over 100. The materials tested had defect levels of 30 or less. The control material that had no protective layer could be rubbed off using thumb pressure - the organic protective material could not. None of the above materials felt slippery and none produced any telescoping during or after rolling.

Example 5

Using the technique of Example 1, a Vitel PE 200 polyester coating was applied in a thickness of 10 nm to various metal layers including

1) Tin
2) Copper
3) Aluminum/Mg (Al 94.8%; Mg 5.0%; Mn 0.1%; Cr 0.1%)
4) Aluminum plus Iron (ratio $Al_2Fe_5$)
5) Nickel

A control non-organic coated layer was included for each metal while thumb action rubbing was able to remove the unprotected metal. The protected metal layers (organic coated) would not rub off.

Example 6

On a 4 mil polyester base containing a vapor coated 700Å aluminum layer and a 50Å (Goodyear Vitel® PE 200) polyester protective layer, a brown dye (Crompton & Knowles Intertherm brown #1303) was vapor coated. This layer was vapor coated at a pressure of $10^{-4}$ torr by heating a crucible or boat containing a dye (boat temperature 140°F) until sufficient density to produce a color (O.D. greater than 0.3) on the metal layer was evident. After the vacuum was removed and the composite removed for examination, the transmission optical density of the dye only was found to be 1.85 at maximum absorption ( max) (McBeth densitometer Model, TD 904 blue filter reading). An adhesion/cohesion test was performed by using a sliding stress testing machine (as described in J. Pho. Sci. and Eng., Sept.-Oct. 1961, pp. 288-296) and the dye surface was able to withstand an abrasive sliding test of over 1200 gms on its surface without showing the shiny aluminum surface below it. Further immersion and subbing tests indicate no dye removal during this task.

Example 7

On a 4 mil polyester base containing a vapor coated, shiny aluminum layer (700Å) and an abrasion-protective layer of polyester 50Å of Goodyear Vitel® PE 200, a dye layer of Crompton & Knowles XB-2 black dye was applied by vapor deposition. This was done at a pressure of 0.6 microns using a temperature of 150-180°F on the (boat/crucible) containing the dye to a drak black dye density. A McBeth densitometer reading of the total dye plus aluminum dye density read over 10.0 density. Transmission optical density (aluminum density level alone) was 6.85. The dye color would not run off and produced results similar to the adhesion/cohesion results of Example 6 using the stress tester of Example 6.

Example 8

This example was the same as Example 6 except in the same vacuum sequential to the application of the vapor deposition of the dye, a 50Å layer of Goodyear Vitel® PE 200 was applied. A resultant transmission density of 2.31 was observed in this layer. An organic coating of the photoresist disclosed in U.S. Serial No. 350,737 (filed February 22, 1982) was applied and dried. After exposure to Berkey Ascor 2kw Exposing Device (light to film distance about 1 mtr.) for 30 seconds, it was developed using the processing solution and technique of Example 3 of U.S. Patent No. 4,314,022. A black colored image was observed. Both the black image and a shiny aluminum one produced from material identical to the black film but without the vapor deposited dye layer were put into a 3M Microfilm Reader Printer Model 312 whose optical train was slightly misaligned. The black image could be viewed easily on the printer screen with good contrast. The non-dye image appeared flat, difficult to view and washed out.

Example 9

The same as Example 8 with a Resinox® novolak resin as the protective layer with identical results noted.

Examples 10-11

The same as Examples 8 and 9 except that the photoresist layer was that of Example 3 of U.S. Patent No. 4,247,616 was laminated over the black layer and there was no protective interlayer. After exposure and development, a black image was evident as viewed through the remaining resist layer.

Example 12

Class of material: perylene pigment
Description of sample(s):

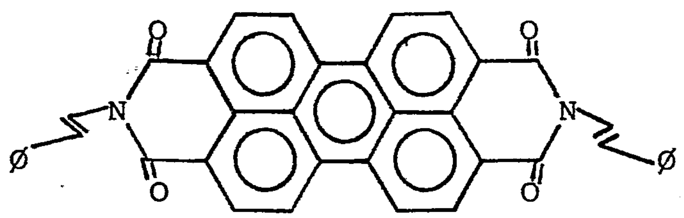

A pigment of the above construction (commercial name perylene green) was vapor coated onto a 4 mil polyester web containing a 700Å layer of vapor coated aluminum and 50Å of Vitel® PE 200. The transmission optical density of the aluminum/polyester/pigment film registered over 13.0 - Sample A; a second sample of film was prepared identical to the first (herewith known as Sample B except that an additional 100Å of the same polyester was vapor coated over the base/aluminum/polyester/dye package; a third sample was prepared without the polyester interlayer between the dye and the vapor coated aluminum Sample C.

Samples A, B and C were subsequently overcoated with the photoresist layer described in Example 3 of U.S. Patent No. 4,247,616.

These samples were exposed for 30 seconds to a UV rich source Berkey Ascor 2kw printer and developed in the processing chemistry of U.S. Patent No. 4,314,022.

An antireflection black layer was evident on the formerly photosensitive side of the film. No deterioration of the image quality was observed.

Example 13

Example 8 was repeated with the following materials used in place of the aforementioned dye/pigment materials.

1) An anthroquinnone dye

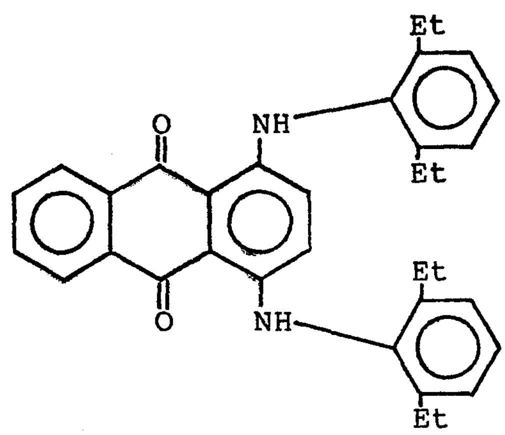

A purple blue color image was obtained.

2)

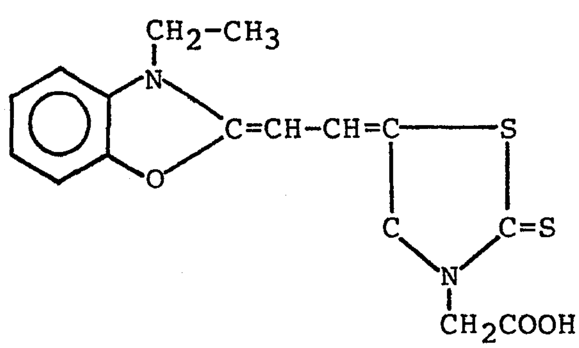

A yellow color image was obtained.

3) Rhodamine B dye.

A blue color image was obtained.

4) Seatoflavine dye.

A grey color image was obtained.

5) Phthalocyanine Blue Pigment.

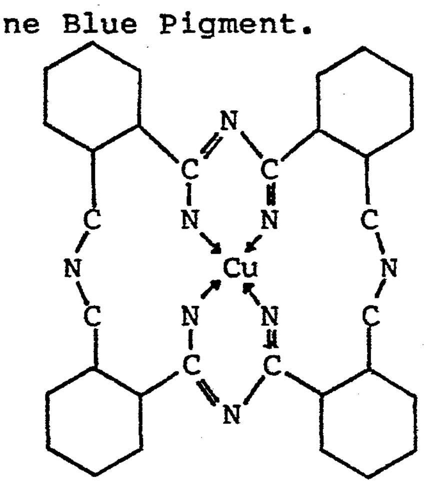

A blue color image was obtained.

CLAIMS

1. An imageable article comprising a substrate having on at least one surface thereof a vapor-deposited colorant layer having an optical density greater than 0.3 and over said colorant layer a photosensitive resist layer which is non-integral with said colorant layer.

2. The article of claim 1 wherein said substrate comprises a polymeric film.

3. The article of claim 1 wherein said substrate comprises a polymeric film having a vapor-deposited metal layer of at least 3 nm thickness on one surface thereof and said colorant material is between the metal layer and the resist layer.

4. The article of claim 1 wherein said substrate comprises a polymeric film having a vapor-deposited metal layer of at least 3 nm thickness on one surface thereof, a vapor-deposited, organic abrasion-protective layer directly on said metal layer, and said colorant is over the abrasion protective layer.

5. The article of claims 1-4 wherein a vapor-deposited organic barrier layer is between the colorant layer and the photosensitive resist layer and is directly on the colorant layer.

6. The article of claims 1-4 wherein said vapor deposited metal layer has adhered to it a layer of 1 to 600 nm comprising an organic material having a vapor pressure at 20°C less than or equal to that of 1-n-octanol and having a) a carbonyl group, b) a phenoxy group, c) an ester group, d) saccharide, or e) an alcohol group.

7. The article of claim 6 wherein at least 50% of the thickness of said metal layer consists essentially of a material selected from the group consisting of metals, metal compounds, metal salts and combinations thereof.

8. The article of claims 1-4 wherein said organic abrasion-protective layer comprises a material selected from the group consisting of amides, anilides, bisphenol A, phenol formalde resins, polyester resins having a molecular weight between 5,000 and 50,000, and alcohols having a vapor pressure at 20°C no higher than that of 1-n-octanol.

9. The article of claims 1-4 having coated over said organic material a positive-acting photoresist layer.

10. The article of claim 5 having coated over said colorant layer a positive acting photoresist layer and wherein said metal layer is from 10 to 500 nm in average thickness and consists of metal, metal oxide or combinations thereof and said organic layer is from 3 to 200 nm thick.